# EUROPÄISCHE PATENTSCHRIFT

(11) **EP 2 122 784 B1**
(45) Veröffentlichungstag und Bekanntmachung des Hinweises auf die Patenterteilung: **15.01.2014**
(21) Anmeldenummer: 08706854.0
(22) Anmeldetag: 02.02.2008
(51) Int. Cl.: H01R 13/405, H01R 43/24, H01R 13/66, B29C 45/14, G01P 1/02, H05K 5/06

(54) **SENSORANORDNUNG**
SENSOR ARRANGEMENT
ENSEMBLE CAPTEUR

(30) Priorität: 19.03.2007 DE 102007014279
(43) Veröffentlichungstag der Anmeldung: 25.11.2009
(73) Patentinhaber: Conti Temic Microelectronic GmbH, 90411 Nürnberg (DE)
(72) Erfinder: KARRER, Helmut, 90762 Fürth (DE); HENNIGER, Jürgen, 91056 Erlangen (DE); SCHULZE, Andreas, 81207 Lauf (DE); WIECZOREK, Matthias, 91233 Neunkirchen a. Sand (DE); WENK, Alexander, 91595 Burgoberbach (DE); FARNBACHER, Ingrid, 90766 Fürth (DE)
(86) Internationale Anmeldenummer: PCT/DE2008/000189
(87) Internationale Veröffentlichungsnummer: WO 2008/113312

(56) Entgegenhaltungen:
- WO-A-93/14618
- DE-A1- 3 611 224
- DE-A1-102005 039 086
- US-B1- 6 287 502
- US-B1- 6 427 316

## Beschreibung

Die Erfindung betrifft ein Verfahren zur Herstellung einer Sensoranordnung.

Sensoranordnungen finden insbesondere in der Automobilindustrie Anwendung. Der Einbauort derartiger Sensoranordnungen ist insbesondere ein Getriebe oder ein Motorraum eines Kraftfahrzeugs. Die Sensorelemente einer derartigen Sensoranordnung dienen beispielsweise zur Ermittlung einer Motordrehzahl oder eines Bauteilweges. Die Sensorelemente werden über die Kontaktstifte mit externen Auslese- oder Steuergeräten elektrisch kontaktiert. Kontaktelemente werden hierbei mit einem Kunststoffkörper ummantelt.

Eine Sensoranordnung bekannter Art ist in US 6 427 316 B1 offenbart.

Es ist eine Aufgabe der vorliegenden Erfindung, eine Sensoranordnung der eingangs genannten Art derart weiterzubilden und herzustellen, dass deren Fertigungsaufwand bei gleicher Sicherheit gegen eine unerwünschte elektrostatische Entladung bzw. gegen die Bildung eines unerwünschten Kurzschlusses verringert ist.

Diese Aufgabe ist erfindungsgemäß gelöst durch das Verfahren mit den im Anspruch 1 angegebenen Schritten und eine Sensoranordnung nach Anspruch 6.

Erfindungsgemäß wurde erkannt, dass auf ein zweistufiges Spritzverfahren zur Ummantelung des Kontaktelements mit dem Kunststoffkörper verzichtet werden kann, wenn um die Fixierpositionen umlaufende Kragen aus Kunststoffmaterial vorgesehen werden. Hierdurch wird der Abstand zwischen einer benachbart zu den Fixierpositionen vorliegenden Oberfläche des Kunststoffkörpers einerseits zur freiliegenden Stelle des Kontaktelements an dieser Fixierposition andererseits auf ein Maß vergrößert, bei dem während der Montage der Sensoranordnung oder des weiteren Kraftfahrzeuges sowie während des Einsatzes des Kraftfahrzeuges weder eine elektrische Entladung noch ein Kurzschluss stattfinden kann. Insbesondere ist aufgrund der Kragen eine Strecke zwischen freiliegenden Stellen benachbarter Fixierpositionen so vergrößert, dass es zu keinen Kurzschlüssen beispielsweise durch Metallspäne, insbesondere beim Einsatz der Sensoranordnung in einem Getriebe, kommen kann.

Weitere Details und Ausführungen sind in den entsprechenden abhängigen Ansprüchen definiert.

Ausführungsbeispiele der Erfindung werden nachfolgend anhand der Zeichnung näher erläutert. In dieser zeigen:
- Fig. 1: eine perspektivische Ansicht einer Sensoranordnung;
- Fig. 2: eine Aufsicht auf eine weitere Ausführung einer Sensoranordnung; und
- Fig. 3: einen Schnitt gemäß Linie III-III in Fig. 2.

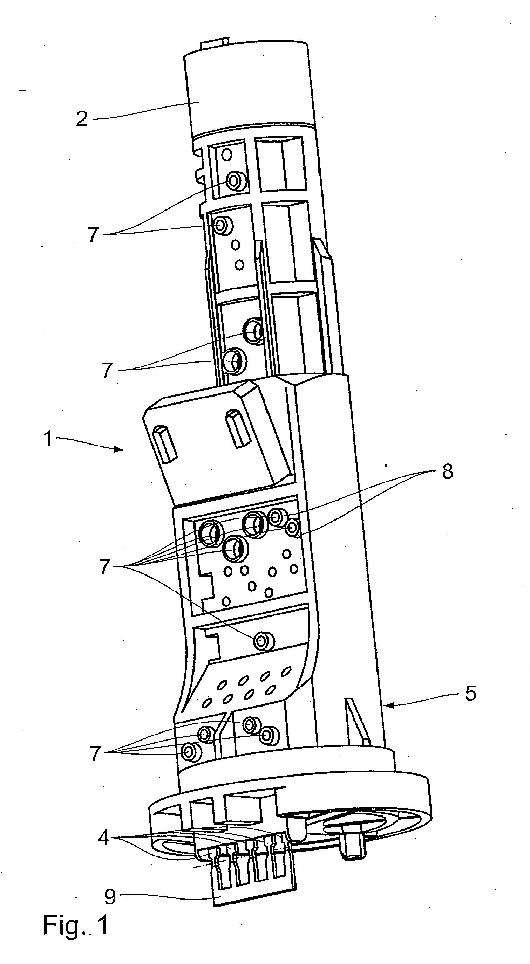

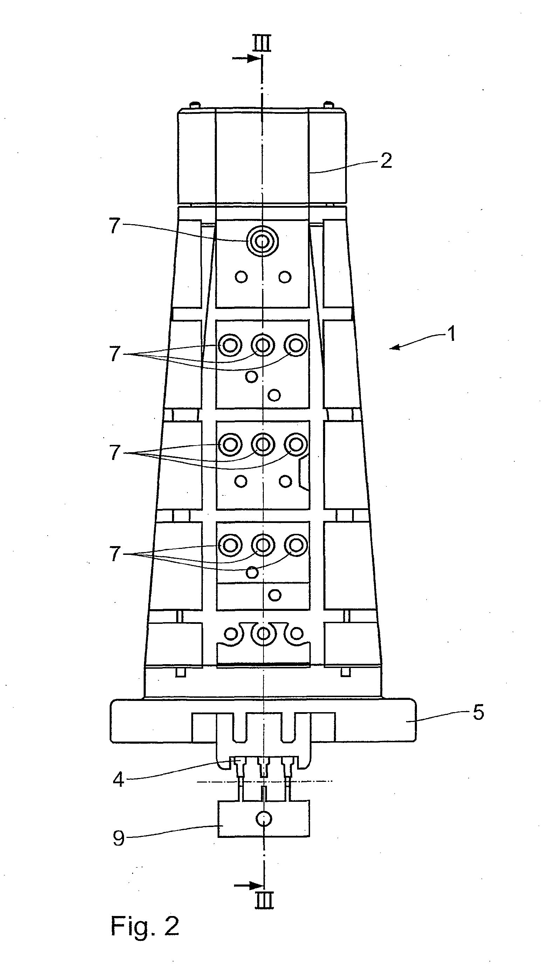

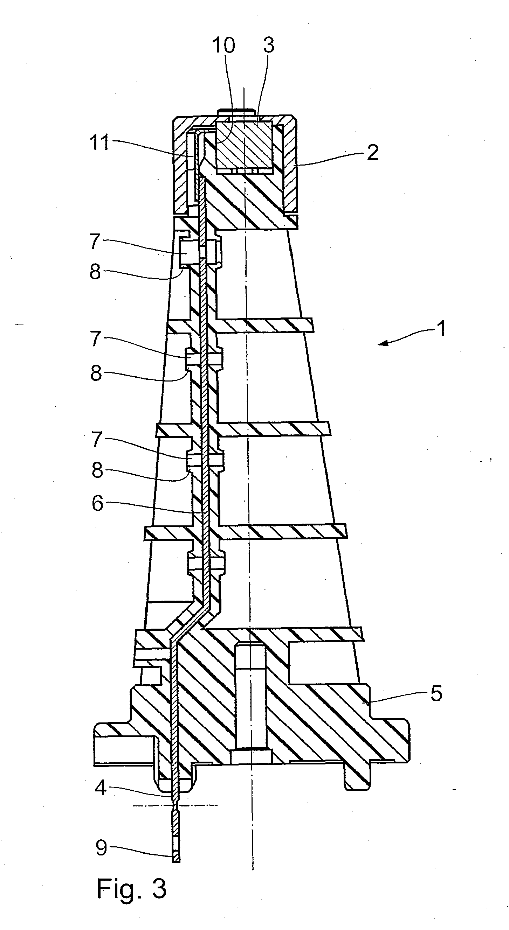

Eine Sensoranordnung 1 hat ein bei der Ausführung nach Fig. 1 von einem Spanschutzdeckel 2 abgedecktes und daher nicht sichtbares Sensorelement. Die Anordnung des Sensorelements der Ausführung nach Fig. 1 entspricht derjenigen eines Sensorelements 3 der weiteren Ausführung einer Sensoranordnung nach den Fig. 2 und 3.

Zur Signalverbindung des Sensorelements mit einem in der Zeichnung nicht näher dargestellten externen Auslese- und Steuergerät dienen Kontaktstifte 4. Letztere sind an einem dem Sensorelement gegenüberliegenden Ende eines Kunststoffkörpers 5 der Sensoranordnung 1 angeordnet. Der Kunststoffkörper 5 wird auch als Sensordom bezeichnet. Der Spanschutzdeckel 2, der zum Schutz des Sensorelements 3 dient, ist insbesondere lösbar mit dem Kunststoffkörper 5 verbunden, beispielsweise mit diesem verrastet oder mit diesem heißverstemmt. Insgesamt liegen bei der Ausführung nach Fig. 1 fünf nebeneinander aus dem Kunststoffkörper 5 herausgeführte Kontaktstifte 4 vor.

Mit dem Sensorelement einerseits und mit den Kontaktstiften 4 andererseits in elektrischem Kontakt steht ein Kontaktelement 6, das auch als Stanzgitter bezeichnet ist. Das Kontaktelement 6 ist aus einer Kupferlegierung. Das Kontaktelement 6 bildet Leiter- bzw. Kontaktbahnen, die den Kontaktstiften jeweils zugeordnet sind und von jeweiligen Anschlusspunkten des Sensorelements 3 hin zu den Kontaktstiften 4 führen. Das Kontaktelement 6 ist mit dem Kunststoffkörper 5 umspritzt. Hierbei kommt ein einstufiges Umspritzverfahren zum Einsatz. Bei diesem einstufigen Umspritzvorgang wird das Kontaktelement 6 an Fixierpositionen 7 in einem Spritzwerkzeug aufgenommen bzw. gehalten. Insgesamt sind dem Betrachter aus der Perspektive nach Fig. 1 vierzehn derartige Fixierpositionen 7 zugewandt. Nach dem Umspritzvorgang liegt an den Fixierpositionen 7 daher kein angespritzter Kunststoff vor, die Fixierpositionen 4 liegen also frei.

Um die von Kunststoffmaterial nach dem Umspritzen freiliegenden Stellen der Fixieipositionen 7 herum weisen die Fixierpositionen 7 jeweils einen umlaufenden Kragen 8 aus dem gespritzten Kunststoffmaterial auf. Je nach der Form von Aufnahmeelementen des Spritzwerkzeugs werden dabei die Kragen 8 mit unterschiedlichem Durchmesser und unterschiedlicher Kragenwandstärke ausgeformt. Bei der Sensoranordnung 1 nach Fig. 1 liegen fünf Kragen 8 mit vergleichsweise großem Durchmesser und vergleichsweise geringer Wandstärke und neun Kragen 8 mit vergleichsweise kleinerem Durchmesser und vergleichsweise größerer Wandstärke vor. Die Kragen 8 haben über den sonstigen Kunststoffkörper 5 einen Überstand von etwa 1 mm.

An den Kragen 8 mit kleinerem Durchmesser wird das Stanzgitter 6 gehalten, also fixiert. Bei den Kragen 8 mit größerem Kragendurchmesser wird das Stanzgitter 6 aufgenommen und fixiert. Für diese Aufnahme hat das Stanzgitter 6 eine Bohrung.

Da die Kragen 8 beim Umspritzen des Kontaktelements 6 mit dem den Kunststoffkörper 5 aufbauenden Kunststoffmaterial erzeugt werden, sind die Kragen 8 einstückig an den Kunststoffkörper 5 angeformt.

Die Kragen 8 sorgen dafür, dass die von Kunststoffmaterial freiliegenden Stellen der Fixierpositionen 7 keine unerwünschten Kontakte mit externen Bauteilen oder mit Spänen bilden.

Während der Herstellung der Sensoranordnung 1 sind die später freien Enden der Kontaktstifte 4 untereinander über einen Verbindungssteg bzw. Verbindungskörper 9 miteinander verbunden. Der Verbindungssteg 9 liegt insgesamt frei, wird also nicht umspritzt. Der Verbindungssteg 9 liegt also komplett außerhalb des Kunststoffkörpers 5.

Die Sensoranordnung 1 nach Fig. 1 wird folgendermaßen hergestellt: Zunächst wird das Kontaktelement 6 in das Spritzgusswerkzeug eingelegt. Dadurch, dass die einzelnen Leiterbahnen über den Verbindungssteg 9 zueinander relativ vorpositioniert sind, ist dieses Einlegen gegenüber einem Einlegen aller Leiterbahnen des Kontaktelements 6 einzeln erleichtert. Anschließend wird das Kontaktelement 6 mit dem Kunststoffkörper 5 umspritzt. Dann wird das Sensorelement 3 in eine Aufnahme 10 (vgl. Fig. 2) des Kunststoffkörpers 5 eingesetzt und Kontaktpins 11 des Sensorelements 3 werden mit den zugeordneten Leiterbahnen des Kontaktelements 6 verbunden (vgl. hierzu ebenfalls die Fig. 3). Anschließend wird der Spanschutzdeckel 2 auf den Kunststoffkörper 5 aufgesetzt und mit diesem verbunden.

Beim Umspritzen des Kontaktelements 6 in genau einem Spritzschritt werden gleichzeitig die Kragen 8 angeformt. Schließlich wird der Verbindungssteg 9 von den Kontaktstiften 4 abgestanzt, so dass die freien Enden der Kontaktstifte 4 zur Verbindung mit einem externen Auslese- und Steuergerät freiliegen.

Zusätzlich können die angeformten Kragen 8 über den Fixierpositionen 7 verstemmt werden, so dass das Material der Kragen 8 die freiliegenden Stellen der Fixierpositionen verschließt. Hierdurch wird eine zusätzliche Sicherheit vor einer unerwünschten elektrischen Kontaktierung von außen her geschaffen.

Fig. 2 und 3 zeigen eine weitere Ausführung einer Sensoranordnung 1. Komponenten, die denjenigen entsprechen, die vorstehend unter Bezugnahme auf die Fig. 1 erläutert wurden, tragen die gleichen Bezugsziffern und werden nicht nochmals im Einzelnen diskutiert.

Die Sensoranordnung 1 nach den Fig. 2 und 3 unterscheidet sich von derjenigen nach Fig. 1 durch die Größe und Form des Kunststoffkörpers bzw. Sensordoms 5 sowie durch die Anordnung der Fixierpositionen 7 und der Gestaltung von deren Kragen 8. Bei der Sensoranordnung 1 nach den Fig. 2 und 3 liegt insgesamt eine Hülse mit vergleichsweise großem Durchmesser und es liegen weiterhin neun Fixierpositionen 7 mit Kragen 8 mit vergleichsweise kleinem Durchmesser vor.

Dem Schnitt nach Fig. 3 ist zu entnehmen, dass an den Fixierpositionen 7 das Kontaktelement 6 jeweils von zwei gegenüberliegenden Seiten im Spritzwerkzeug gehalten ist.

Im Unterschied zur Ausführung nach Fig. 1 weist die Ausführung der Sensoranordnung 1 nach den Fig. 2 und 3 insgesamt drei nebeneinander aus dem Kunststoffkörper 5 herausgeführte Kontaktstifte 4 auf.

Die Herstellung der Sensoranordnung 1 nach den Fig. 2 und 3 entspricht derjenigen der Sensoranordnung 1 nach Fig. 1.

## Patentansprüche

1. Verfahren zur Herstellung einer Sensoranordnung (1), umfassend ein Kontaktelement (6) und ein Sensorelement (3), wobei das Kontaktelement (6) einerseits mit dem Sensorelement (3) und andererseits mit Kontaktstiften (4) in elektrischem Kontakt steht, mit folgenden Schritten:
- Einlegen eines Kontaktelements (6) in ein Spritzgusswerkzeug,
- Umspritzen des Kontaktelements (6) mit einem Kunststoffkörper (5) in genau einem Umspritzvorgang, wobei das Kontaktelement (6) im Spritzgusswerkzeug an Fixierpositionen (7) gehalten wird und die Fixierpositionen (7) nach dem Umspritzvorgang frei liegen,
- Ausformen von Kragen (8) aus Kunststoffmaterial um die Fixierpositionen (7), wobei ein Kragen (8) jeweils eine freiliegende Stelle des Kontaktelements (6) umlaufend ausgeformt ist,
- Einsetzen des Sensorelements (3) in eine Aufnahme (10) des Kunststoffkörpers (5),
- Kontaktieren des Sensorelements (3) mit dem Kontaktelement (6).

2. Verfahren nach Anspruch 1, **dadurch gekennzeichnet, dass** beim Umspritzen gleichzeitig die Kragen (8) um die Fixierpositionen (7) ausgeformt werden.

3. Verfahren nach Anspruch 1 oder 2, **dadurch gekennzeichnet, dass** das Kontaktelement (6) während des Umspritzens über einen Verbindungskörper (9) gehalten ist, der einstückig an das Kontaktelement (6) angeformt ist, wobei das Kontaktelement (6) vom Verbindungskörper (9) nach dem Umspritzen getrennt wird.

4. Verfahren nach Anspruch 3, **dadurch gekennzeichnet, dass** das Kontaktelement (6) am Verbindungskörper (9) über alle Kontaktstifte (4) verbunden ist.

5. Verfahren nach einem der Ansprüche 1 bis 4, **dadurch gekennzeichnet, dass** nach dem Anformen der Kragen (8) diese über den Fixierpositionen (7) verstemmt werden, so das nach dem Verstemmen die vorher freiliegenden Stellen des Kontaktelements (6) an den Fixierpositionen (7) nicht mehr freiliegen.

6. Sensoranordnung (1), umfassend ein Kontaktelement (6) und ein Sensorelement (3), hergestellt gemäß einem Verfahren nach einem der Ansprüche 1 bis 5.

7. Sensoranordnung nach Anspruch 6, **dadurch gekennzeichnet, dass** die Kragen (8) jeweils einstückig an den Kunststoffkörper (5) angeformt sind.

8. Sensoranordnung nach Anspruch 6 oder 7, **gekennzeichnet durch** einen das Sensorelement (3) zumindest abschnittsweise abdeckenden Deckel (2), der mit dem Kunststoffkörper (5) verbunden ist.

## Claims

1. A method for manufacturing a sensor arrangement (1) comprising a contact element (6) and a sensor element (3), wherein the contact element (6) is in electric contact with the sensor element (3) on the one hand and with connector pins (4) on the other hand, having the following steps:
• putting a contact element (6) into a mould for injection molding,
• injection-molding a plastic body (5) around the contact element (6) in exactly one injection-molding operation, wherein the contact element (6) is fixed in the mould in fixing positions (7) and the fixing positions (7) are exposed after the injection-molding operation,
• shaping plastic collars (8) around the fixing positions (7), wherein each collar (8) is shaped as a circumferential collar around an exposed spot of the contact element (6),
• inserting the sensor element (3) into a retainer (10) of the plastic body (5),
• contacting the sensor element (3) to the contact element (6).

2. The method according to claim 1, **characterized in that** the processes of shaping the collars (8) around the fixing positions (7) and of injection-molding around the contact element (6) are performed simultaneously.

3. The method according to claim 1 or 2, **characterized in that** the contact element (6) is held by means of a connecting body (9) during the process of injection-molding around the contact element (6), which connecting body (9) is integrally molded on the contact element (6), wherein the contact element (6) is separated from the connecting body (9) after the process of injection-molding around the contact element (6).

4. The method according to claim 3, **characterized in that** the contact element (6) is connected to the connecting body (9) via all connector pins (4).

5. The method according to any one of claims 1 to 4, **characterized in that** the collars (8) are calked above the fixing positions (7) after molding the collars (8) on so that the previously exposed spots of the contact element (6) are not exposed in the fixing positions (7) any longer after the calking process.

6. A sensor arrangement (1) comprising a contact element (6) and a sensor element (3) manufactured according to a method according to any one of claims 1 to 5.

7. The sensor arrangement according to claim 6, **characterized in that** each collar (8) is integrally molded on the plastic body (5).

8. The sensor arrangement according to claim 6 or 7, **characterized by** a cover (2) that covers the sensor element (3) at least partially and is connected to the plastic body (5).

## Revendications

1. Procédé de fabrication d'un dispositif de capteur (1), comprenant un élément de contact (6) et un élément de capteur (3), l'élément de contact (6) étant en contact électrique d'un côté avec l'élément de capteur (3) et de l'autre côté avec des broches de contact (4), comprenant les étapes suivantes :
- insertion d'un élément de contact (6) dans un outil de moulage par injection,
- enrobage de l'élément de contact (6) avec un corps en matière plastique (5) en précisément un processus d'enrobage, l'élément de contact (6) étant retenu dans l'outil de moulage par injection dans des positions de fixation (7), et les positions de fixation (7) étant exposées après le processus d'enrobage,
- formation de cols (8) en matière plastique autour des positions de fixation (7), un col (8) étant respectivement formé en entourant un emplacement exposé de l'élément de contact (6),
- introduction de l'élément de capteur (3) dans un logement (10) du corps en matière plastique (5),
- mise en contact de l'élément de capteur (3) avec l'élément de contact (6).

2. Procédé selon la revendication 1, **caractérisé en ce que,** lors de l'enrobage, les cols (8) sont en même temps formés autour des positions de fixation (7).

3. Procédé selon la revendication 1 ou 2, **caractérisé en ce que** l'élément de contact (6) est retenu pendant l'enrobage par le biais d'un corps de raccordement (9) qui est formé d'un seul tenant sur l'élément de contact (6), l'élément de contact (6) étant séparé du corps de raccordement (9) après l'enrobage.

4. Procédé selon la revendication 3, **caractérisé en ce que** l'élément de contact (6) est raccordé sur le corps de raccordement (9) par le biais de toutes les broches de contact (4).

5. Procédé selon une des revendications 1 à 4, **caractérisé en ce que,** après la formation des cols (8), ceux-ci sont matés sur les positions de fixation (7) de telle sorte que, après le matage, les emplacements préalablement exposés de l'élément de contact (6) ne sont plus exposés sur les positions de fixation (7).

6. Dispositif de capteur (1), comprenant un élément de contact (6) et un élément de capteur (3), fabriqué suivant un procédé selon une des revendications 1 à 5.

7. Dispositif de capteur selon la revendication 6, **caractérisé en ce que** les cols (8) sont respectivement formés d'un seul tenant sur le corps en matière plastique (5).

8. Dispositif de capteur selon la revendication 6 ou 7, **caractérisé par** un couvercle (2) qui recouvre au moins par tronçons l'élément de capteur (3) et qui est raccordé au corps en matière plastique (5).
